(19) Europäisches Patentamt

European Patent Office

Office européen des brevets

(11) **EP 1 016 087 B1**

(12) **EUROPÄISCHE PATENTSCHRIFT**

(45) Veröffentlichungstag und Bekanntmachung des Hinweises auf die Patenterteilung:
**05.06.2002 Patentblatt 2002/23**

(21) Anmeldenummer: **98952536.5**

(22) Anmeldetag: **02.09.1998**

(51) Int Cl.⁷: **G11C 11/15**

(86) Internationale Anmeldenummer:
**PCT/DE98/02589**

(87) Internationale Veröffentlichungsnummer:
**WO 99/14760 (25.03.1999 Gazette 1999/12)**

(54) **SPEICHERZELLENANORDNUNG UND DEREN VERWENDUNG ALS MAGNETISCHES RAM UND ALS ASSOZIATIVER SPEICHER**

MEMORY LOCATION ARRANGEMENT AND ITS USE AS A MAGNETIC RAM AND AS AN ASSOCIATIVE MEMORY

CONFIGURATION DE CELLULE DE MEMOIRE ET SON UTILISATION COMME MEMOIRE A ACCES ALEATOIRE MAGNETIQUE ET COMME MEMOIRE ASSOCIATIVE

(84) Benannte Vertragsstaaten:
**DE FR GB IE IT**

(30) Priorität: **17.09.1997 DE 19740942**

(43) Veröffentlichungstag der Anmeldung:
**05.07.2000 Patentblatt 2000/27**

(73) Patentinhaber: **Infineon Technologies AG**
**81669 München (DE)**

(72) Erfinder:
• **RAMCKE, Ties**
**D-81739 München (DE)**
• **RÖSNER, Wolfgang**
**D-81739 München (DE)**
• **RISCH, Lothar**
**D-85579 Neubiberg (DE)**

(74) Vertreter: **Zimmermann & Partner**
**Postfach 33 09 20**
**80069 München (DE)**

(56) Entgegenhaltungen:
**EP-A- 0 613 148         EP-A- 0 685 849**
**WO-A-99/18578           US-A- 5 173 873**
**US-A- 5 432 734**

**Beschreibung**

Die Erfindung betrifft eine Speicherzellenanordnung mit Speicherelementen mit einer Schichtstruktur mit sehr großem magnetoresistivem Effekt (GMR).

Der Begriff GMR-Element wird in der Fachwelt für Schichtstrukturen verwendet, die mindestens zwei ferromagnetische Schichten und eine dazwischen angeordnete nicht magnetische Schicht aufweisen und den sogenannten GMR-(giant magnetoresistiver) Effekt, das heißt sehr großen magnetoresistiven Effekt zeigen. Unter dem GMR-Effekt wird die Tatsache verstanden, daß der elektrische Widerstand des GMR-Elements abhängig davon ist, ob die Magnetisierung in den beiden ferromagnetischen Schichten parallel oder antiparallel ausgerichtet sind.

Es ist vorgeschlagen worden (siehe zum Beispiel D. D. Tang et al, IEDM 95, Seiten 997 bis 999, D. D. Tang et al, IEEE Trans. on Magnetics, Vol. 31, Nr. 6, 1995, Seiten 3206 bis 3208, F. W. Patten et al, Int. Non Volatile Memory Technology Conf., 1996, Seiten 1 bis 2) derartige GMR-Elemente als Speicherelemente in einer Speicherzellenanordnung zu verwenden. Dazu werden als Speicherelemente GMR-Elemente verwendet, bei denen die Magnetisierungsrichtung der einen ferromagnetischen Schicht zum Beispiel durch eine benachbarte antiferromagnetische Schicht festgehalten wird. Die Speicherelemente werden über Bitleitungen in Reihe verschaltet. Quer dazu verlaufen Wortleitungen, die sowohl gegenüber den Bitleitungen als auch gegenüber den Speicherelementen isoliert sind. An die Wortleitungen angelegte Signale verursachen durch den in der Wortleitung fließenden Strom ein Magnetfeld, das die darunter befindlichen Speicherelemente beeinflußt. Zum Einschreiben von Information werden eine Bitleitung und eine Wortleitung, die sich oberhalb der zu beschreibenden Speicherzelle kreuzen, mit Signalen beaufschlagt, die am Kreuzungspunkt ein für die Ummagnetisierung ausreichendes magnetisches Feld verursachen. Zum Auslesen der Information wird die Wortleitung mit einem gepulsten Signal beaufschlagt, durch das die betreffende Speicherzelle zwischen den beiden Magnetisierungszuständen hin und her geschaltet wird. Gemessen wird der Strom durch die Bitleitung, aus der der Widerstandswert des entsprechenden Speicherelementes ermittelt wird.

In S. Tehrani et al, IEDM 96, Seite 193 ff., ist vorgeschlagen worden, als Speicherelement ein GMR-Element zu verwenden, das unterschiedliche dikke ferromagnetische Schichten aufweist. Das Magnetfeld zum Einschreiben von Information wird so bemessen, daß es nur die Magnetisierung in der dünneren der beiden ferromagnetischen Schichten beeinflußt. Die Magnetisierung in der dickeren der beiden ferromagnetischen Schichten bleibt davon unbeeinflußt.

Der Auslesevorgang mit gepulsten Signalen erfordert in diesen Speicherzellenanordnungen einen erhöhten Schaltungsaufwand.

Der Erfindung liegt das Problem zugrunde, eine Speicherzellenanordnung mit GMR-Elementen anzugeben, die mit verringertem Schaltungsaufwand ausgelesen werden kann.

Dieses Problem wird durch eine Speicherzellenanordnung gemäß Anspruch 1 gelöst. Weitere Ausgestaltungen der Erfindung gehen aus den übrigen Ansprüchen hervor.

Die Speicherzellenanordnung weist untereinander im wesentlichen parallel verlaufende Wortleitungen und untereinander im wesentlichen parallel verlaufende Bitleitungen auf, wobei die Wortleitungen quer zu den Bitleitungen verlaufen. Es sind Speicherelemente mit einer Schichtstruktur mit sehr großem magnetoresistiven Effekt (GMR), das heißt GMR-Elemente, vorgesehen, die jeweils zwischen eine der Wortleitungen und eine der Bitleitungen geschaltet sind und die hochohmiger als die Wortleitungen und die Bitleitungen sind. Die Bitleitungen sind jeweils mit einem Leseverstärker verbunden, über den das Potential an der jeweiligen Bitleitung auf ein Referenzpotential regelbar ist und an dem ein Ausgangssignal abgreifbar ist. Zum Auslesen dieser Speicherzellenanordnung werden alle nicht ausgewählten Wortleitungen auf das Referenzpotential gelegt. An die ausgewählte Wortleitung wird ein Signal mit anderem Potential angelegt. Dadurch wird ein Strompfad von der ausgewählten Wortleitung zu allen Bitleitungen geschlossen. Aus dem Ausgangssignal am jeweiligen Leseverstärker, den elektrischen Kenngrößen des Leseverstärkers wie zum Beispiel dem Rückkoppelwiderstand, und dem Referenzpotential und dem Bitleitungswiderstand läßt sich der Widerstand des am Kreuzungspunkt der Wortleitung mit der jeweiligen Bitleitung befindlichen Speicherelementes bestimmen. Zum Auslesen dieser Speicherzellenanordnung ist daher kein gepulstes Signal erforderlich.

Vorzugsweise weist der Leseverstärker einen rückgekoppelten Operationsverstärker auf. Der nicht invertierende Eingang des Operationsverstärkers wird mit Referenzpotential, zum Beispiel mit Erde, verbunden. Die Bitleitung wird mit dem invertierenden Eingang verbunden. Beträgt das Referenzpotential 0 Volt, so stellt dieser Operationsverstärker sicher, daß an der Bitleitung 0 Volt anliegen. Das Ausgangssignal des Operationsverstärkers ist ein Maß für den Widerstand des ausgewählten Speicherelementes.

Als Speicherelement sind alle bekannten GMR-Elemente geeignet, sofern sie in beiden Magnetisierungszuständen hochohmiger als die Bitleitung und die Wortleitung sind. Der GMR-Effekt ist größer, wenn der Strom senkrecht durch den Schichtstapel fließt, als wenn der Strom parallel in den Schichten fließt.

Vorzugsweise weisen die Speicherelemente jeweils zwei ferromagnetische Schichten und eine dazwischen angeordnete nichtmagnetische, isolierende Schicht auf. Eine der ferromagnetischen Schichten ist einer antiferromagnetischen Schicht benachbart angeordnet, die die Polarisationsrichtung der Magnetisierung in der benachbarten ferromagnetischen Schicht bestimmt. Die Speicherelemente weisen jeweils zwei Magnetisierungszustände auf. Es ist vorteilhaft, eine isolierende, nicht magnetische Schicht zu verwenden, da in diesen Aufbauten der GMR-Effekt, der durch einen spinpolarisierten Tunnelstrom durch die zwischen den beiden ferromagnetischen Schichten angeordnete isolierende, nicht magnetische Schicht bewirkt wird, viel größer ist als bei Verwendung einer nicht isolierenden, nicht magnetischen Schicht. Dadurch lassen sich die unterschiedlichen Widerstandswerte, die in der Speicherzellenanordnung zwei verschiedenen logischen Werten Null und Eins zugeordnet werden, besser unterscheiden.

Alternativ können die Speicherelemente jeweils zwei ferromagnetische Schichten und eine dazwischen angeordnete nicht magnetische Schicht aufweisen, wobei eine der ferromagnetischen Schichten dikker als die andere ferromagnetische Schicht ist oder die ferromagnetischen Schichten aus verschiedenen Materialien mit unterschiedlichen magnetischen Eigenschaften gebildet sind, oder eine nicht magnetische nicht isolierende Schicht aufweisen.

Für die ferromagnetischen Schichten sind unter anderem Materialien geeignet, die mindestens eines der Elemente Fe, Ni, Co, Cr, Mn, Gd enthalten. Die Dikke der ferromagnetischen Schichten beträgt maximal 20 nm und liegt vorzugsweise im Bereich zwischen 2 und 10 nm. Für die nicht magnetische Schicht, die als Tunnelisolator wirkt, ist als isolierendes Material $Al_2O_3$, NiO, $HfO_2$ oder $TiO_2$, NbO, $SiO_2$ geeignet. Als nicht isolierendes Material für die nicht magnetische Schicht ist Cu oder Ag geeignet. Die Dicke der nicht magnetischen Schicht liegt im Bereich zwischen 1 und 4 nm, vorzugsweise zwischen 2 und 3 nm.

Zum Einschreiben von Information in eines der Speicherelemente werden die zugehörige Wortleitung und die zugehörige Bitleitung jeweils mit einem Signal beaufschlagt. Dadurch fließt ein Strom über die Wortleitung und die Bitleitung, der jeweils ein Magnetfeld induziert. Am Kreuzungspunkt der Wortleitung und der Bitleitung ist das Gesamtmagnetfeld, das sich durch Überlagerung der beiden Magnetfelder ergibt, so groß, daß es zu einer Ummagnetisierung des dort befindlichen Speicherelementes kommt. Außerhalb des Kreuzungspunktes sind die einzelnen Magnetfelder für eine Ummagnetisierung der dort befindlichen Speicherelemente zu gering.

In Anwendungen, in denen zum Einschreiben ein erhöhtes Magnetfeld erforderlich oder wünschenswert ist, liegt es im Rahmen der Erfindung, zusätzlich untereinander im wesentlichen parallel verlaufende Schreibleitungen vorzusehen, die zum Beispiel parallel zu den Bitleitungen verlaufen. Diese Schreibleitungen sind gegenüber den Wortleitungen und den Bitleitungen isoliert. Durch Anlegen eines Signals an die entsprechende Schreibleitung kann das Magnetfeld am Kreuzungspunkt mit der ausgewählten Wortleitung verstärkt werden und damit den Schreibvorgang unterstützen.

Die Speicherzellenanordnung ist als magnetisches RAM (MRAM) geeignet.

Darüber hinaus kann die Speicherzellenanordnung als assoziativer Speicher betrieben werden. Dazu wird zu den Bitleitungen jeweils ein Schwellwertelement vorgesehen, das mit dem Ausgang des Leseverstärkers der jeweiligen Bitleitung verbunden ist.

In einem assoziativen Speicher, wie er zum Beispiel aus K. Goser et al, IEEE Micro, 9(1989)6, Seiten 28 bis 44, bekannt ist, wird an allen Wortleitungen gleichzeitig ein Eingangssignal angelegt. Das Eingangssignal weist so viele Stellen wie Wortleitungen auf. An jeder der Bitleitungen wird der Strom aufsummiert und mit einem Schwellwertelement das Ausgangssignal gebildet. In den aus Goser et al, IEEE Micro, 9(1989)6, Seiten 28 bis 44, bekannten assoziativen Speichern besteht die Speicherzelle nur aus einem herkömmlichen Widerstand oder einem Transistor und ist zwischen sich kreuzenden Wortleitungen und Bitleitungen geschaltet. Diese herkömmlichen Widerstände und Transistoren können während des Betriebes nicht verändert werden, so daß der Speicher.nicht lernfähig ist. Alternativ werden die Speicherzellen als EEPROM-Zellen realisiert, so daß ein Programmieren möglich ist, die jedoch aufwendiger herzustellen sind.

Ein Vorteil der erfindungsgemäßen Speicherzellenanordnung bei der Verwendung als assoziativer Speicher ist, daß die GMR-Elemente in den Speicherelementen beliebig oft während des Betriebes umprogrammiert werden können. Daher kann der assoziative Speicher während des Betriebes Information lernen.

Gemäß einer weiteren Ausführungsform der Erfindung ist zu je zwei Bitleitungen ein Differenzverstärker vorgesehen. Die Eingänge des Differenzverstärkers sind jeweils mit dem Ausgang der Leseverstärker der zugehörigen Bitleitungen verbunden. Diese Speicherzellenanordnung wird vorzugsweise ebenfalls als assoziativer Speicher verwendet, wobei jeweils die Speicherelemente in den beiden Bitleitungen, die mit derselben Wortleitung verbunden sind, komplementär zueinander programmiert werden. Beim Auslesen wird auf der einen Bitleitung das komplementäre Signal der anderen gebildet. Aus diesen komplementären Signalen wird im Differenzverstärker das Ausgangssignal gebildet. Diese Differenzmethode verbessert die Störsicherheit gegen Prozeßschwankungen erheblich.

Im folgenden wird die Erfindung anhand von Ausführungsbeispielen, die in den Figuren dargestellt sind, näher erläutert.

Figur 1    zeigt die Architektur einer MRAM- Anordnung.

Figur 2    zeigt ein Speicherelement mit zugehöriger Bitleitung, Wortleitung und Schreibleitung.

Figur 3 zeigt einen assoziativen Speicher, bei dem jede Bitleitung mit einem Schwellwertelement verbunden ist.

Figur 4 zeigt einen assoziativen Speicher, bei dem jeweils zwei benachbarte Bitleitungen komplementär programmiert werden und mit einem Differenzverstärker verbunden sind.

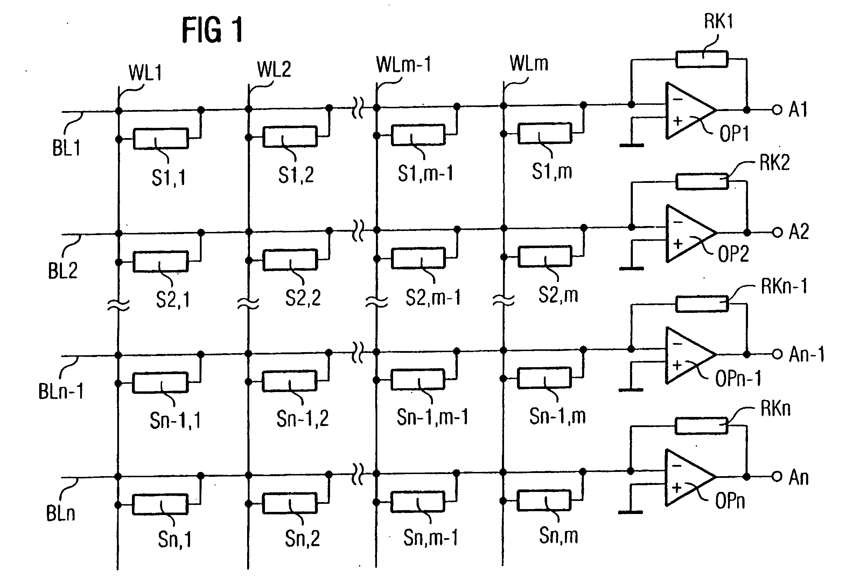

Eine Speicherzellenanordnung weist untereinander im wesentlichen parallel verlaufende Bitleitungen BLi, i = 1, 2, ... n auf. Quer dazu verlaufen Wortleitungen WLj, j = 1, 2, ... m. Die Wortleitungen WLj verlaufen ebenfalls untereinander im wesentlichen parallel. An den Kreuzungspunkten der Bitleitungen BLi mit den Wortleitungen WLj ist jeweils ein Speicherelement Si,j angeordnet (siehe Figur 1).

Die Bitleitungen BLi sind jeweils mit dem invertierenden Eingang eines Operationsverstärkers OPi, i = 1, 2 ... n verbunden. Der nicht invertierende Eingang des Operationsverstärkers OPi ist mit Erdpotential verbunden. Die Operationsverstärker OPi sind rückgekoppelt und weisen jeweils einen Rückkopplungswiderstand RKi auf. Die Operationsverstärker OPi weisen jeweils einen Ausgang Ai auf.

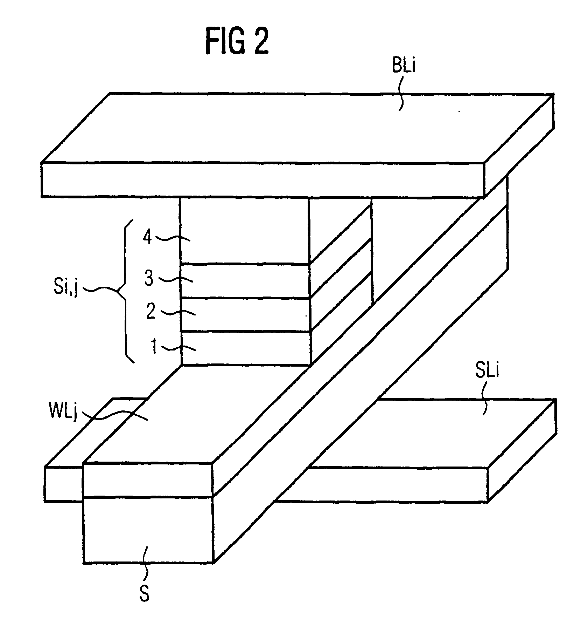

Die Speicherelemente Si,j weisen jeweils eine erste ferromagnetische Schicht 1, eine nicht magnetische Schicht 2, eine zweite ferromagnetische Schicht 3 und eine antiferromagnetische Schicht 4 auf (siehe Figur 2). Die erste ferromagnetische Schicht 1, die nicht magnetische Schicht 2 und die zweite ferromagnetische Schicht 3 stellen eine Schichtstruktur dar. Die erste ferromagnetische Schicht 1 und die zweite ferromagnetische Schicht 3 enthalten zum Beispiel NiFe und weisen eine Dicke von 10 nm auf. Die nicht magnetische Schicht 2 enthält $Al_2O_3$ und weist eine Dicke von 2 bis 3 nm auf. Die antiferromagnetische Schicht 4 enthält FeMn und weist eine Dicke von 10 bis 20 nm auf. In der durch die Bitleitungen BLi und die Wortleitungen WLj aufgespannten Ebene weisen die Speicherelemente Si,j jeweils einen Querschnitt von zum Beispiel 0,25 $\mu$m x 0,25 $\mu$m auf.

Die Bitleitungen BLi und die Wortleitungen WLi werden jeweils aus Al, Cu in einer Dicke gebildet, die so dimensioniert ist, daß die Stromdichte $10^6$ A/cm$^2$ im Al nicht überschreitet.

Die erste ferromagnetische Schicht 1 grenzt an die Wortleitung WLj an. Die antiferromagnetische Schicht 4 grenzt an die Bitleitung BLi an. Die Bitleitung BLi verläuft oberhalb der Wortleitung WLj. Alternativ können die Bitleitungen BLi auch unterhalb der Wortleitungen WLj verlaufen.

Unterhalb der Wortleitungen WLj ist eine isolierende Schicht 5 aus zum Beispiel SiO$_2$ in einer Dicke von 10 nm angeordnet. Sie isoliert die Wortleitung WLj zu einer quer dazu verlaufenden Schreibleitung SLi. Die Schreibleitungen SLi, i = 1 ... n verlaufen untereinander im wesentlichen parallel. Die Schreibleitung SLi verläuft unterhalb der Bitleitung BLi.

In dieser Speicherzellenanordnung wird den logischen Größen Null und Eins jeweils einer der Widerstandswerte der Speicherelemente Si,j zugeordnet.

Zum Auslesen der in der Speicherzellenanordnung gespeicherten Information wird zum Auslesen der in dem Speicherelement Si,j gespeicherten Information die Wortleitung WLj angesteuert. Dazu wird die Wortleitung WLj auf ein Potential von zum Beispiel + 1 Volt gelegt. Alle andere Wortleitungen WL1, 1 $\neq$ j werden auf 0 Volt gelegt. Alle Bitleitungen BLi, i = 1 ... n liegen ebenfalls auf 0 Volt, da sie mit dem invertierenden Eingang des rückgekoppelten Operationsverstärkers OPi verbunden sind, der sich stets auf 0 Volt regelt. Am Ausgang Ai des Operationsverstärkers OPi wird eine Spannung

$$U_{out} = IV^* \frac{R}{(Rx + Rl)}$$

abgegriffen, wobei R der Widerstand des Rückkoppelwiderstandes RKi, Rx der Widerstand des Speicherelementes Si,j und Rl der Widerstand der Leitungsanteile der Wortleitung WLj und der Bitleitung Bli, über die der Strom fließt, ist. Aus dieser Spannung läßt sich der Widerstand Rx des Speicherelementes Si,j berechnen, da die übrigen Größen bekannt sind.

Die Bitleitungen BLi und die Wortleitungen WLj werden aus Metall gebildet, so daß ihr Widerstand sehr klein ist. Der Rückkoppelwiderstand RKi beträgt zum Beispiel 100 k$\Omega$. Der Widerstand Rx des Speicherelementes Si,j beträgt etwa 100 k$\Omega$, falls die Magnetisierung von der ersten ferromagnetischen Schicht 1 und der zweiten ferromagnetischen Schicht 3 parallel ausgerichtet ist und 110 k$\Omega$, falls die Magnetisierung von der ersten ferromagnetischen Schicht 1 und der zweiten ferromagnetischen Schicht 3 antiparallel ausgerichtet ist. Es sind 100 Bitleitungen BLi und 10000 Wortleitungen WLj vorgesehen. Damit beträgt die Änderung des Eingangssignals abhängig von dem angenommenen Widerstandswert des Speicherelementes Si,j 100 mV. Mit einem Widerstandsverhältnis $\frac{R}{(Rx + Rl)}$ von 10 kann sie am Ausgang Ai des Operationsverstärkers OPi auf 1 Volt verstärkt werden.

Da alle Bitleitungen BLi auf 0 Volt liegen, fließen zwischen den Bitleitungen BLi keine parasitären Ströme. Der Strompfad ist nur zwischen der ausgewählten Wortleitung WLj und allen Bitleitungen geschlossen. Es ist daher vorteilhaft, eine größere Anzahl an Wortleitungen WLj als Bitleitungen BLi zu verwenden. Eine Speicherzellenanordnung mit 1 Mbit wird vorzugsweise mit n = 100 Bitleitungen BLi und M = 10.000 Wortleitungen WLj aufgebaut. Damit sind nur 100 Leseverstärker erforderlich. Der Strom, der jeweils in die ausgewählten Wortleitungen BLj fließt, ergibt sich aus der Parallelschaltung von 100 Speicherelementen Si,j, die jeweils einen Widerstand von etwa 100 k$\Omega$ aufweisen. Diese Parallelschaltung weist einen Widerstand von etwa 1 k$\Omega$

auf. Die Länge der Bitleitungen BLi spielt dabei keine Rolle, da diese nicht umgeladen wird.

Zum Einschreiben von Informationen in die Speicherzelle Si,j wird der Schreibleitung SLi und der Wortleitung WLj jeweils ein Strom in der Größenordnung mA eingeprägt. Dieser Strom induziert um die Schreibleitung SLi und die Wortleitung WLj jeweils ein Magnetfeld, das am Kreuzungspunkt der Schreibleitung SLi und der Wortleitung WLj die Magnetisierung der ersten ferromagnetischen Schicht 1 beeinflußt. Die Magnetisierung der zweiten ferromagnetischen Schicht 3 ist durch die antiferromagnetische Schicht 4, die dieser benachbart ist, festgelegt.

Alternativ können die Schreibleitungen SLi parallel zu den Wortleitungen WLj verlaufen. In diesem Fall wird zum Einschreiben von Informationen die Bitleitung BLi und die Schreibleitung angesteuert.

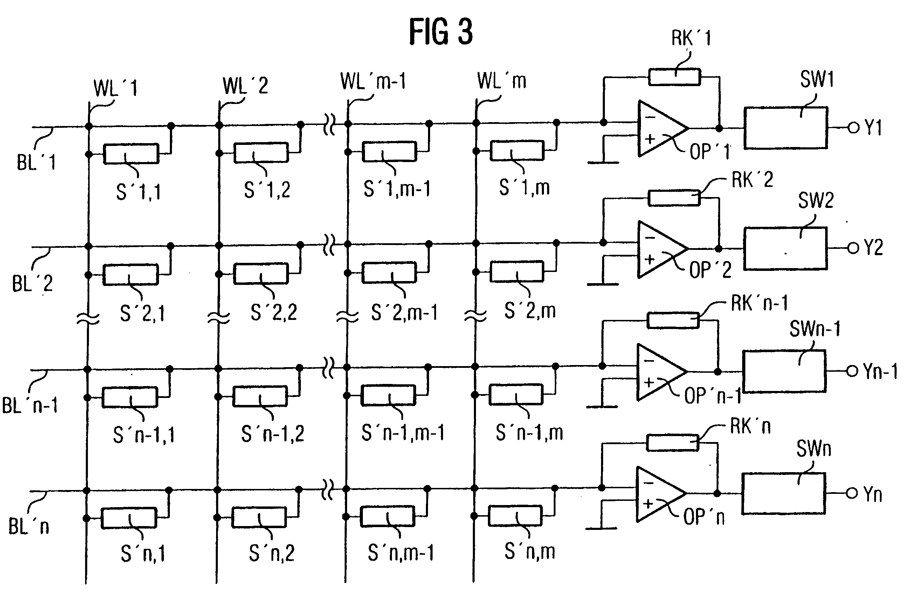

In einer Speicherzellenanordnung, die als assoziativer Speicher einsetzbar ist, sind untereinander parallel verlaufende Wortleitungen WL'j, j = 1 ... m und quer dazu verlaufende, untereinander im wesentlichen parallel verlaufende Bitleitungen BL'i, i = 1 ... n vorgesehen (siehe Figur 3). Am Kreuzungspunkt der Bitleitungen BL'i mit den Wortleitungen WL'j ist jeweils ein Speicherelement S'i,j angeordnet. Die Speicherelemente S'i,j sind analog zu den Speicherelementen Si,j, die anhand von Figur 2 erläutert wurden, aufgebaut. Die Bitleitungen BL'i sind jeweils mit dem invertierenden Eingang eines Operationsverstärkers OP'i verbunden, dessen nicht invertierender Eingang mit Erdpotential verbunden ist und der rückgekoppelt ist. Die Operationsverstärker OP'i weisen einen Rückkopplungswiderstand RK'i auf. Der Ausgang der Operationsverstärker OP'i ist mit dem Eingang eines Schwellwertelementes SWi verbunden. Als Schwellwertelement SWi ist zum Beispiel ein Operationsverstärker mit sehr hoher Verstärkung, zum Beispiel $\geq 100$, oder ein Schmitt-Trigger geeignet. Die Dimensionierung der Operationsverstärker OP'i erfolgt analog wie in dem anhand von Figur 1 und 2 erläuterten Ausführungsbeispiel.

Die Speicherelemente S'i,j sind frei programmierbar. Dazu fließt durch die Bitleitung BL'i und die Wortleitung WL'j Strom. Dabei werden um die Bitleitung BL'i und die Wortleitung WL'j Magnetfelder induziert. Die Ströme werden so gewählt, daß das resultierende Magnetfeld am Kreuzungspunkt der Bitleitung BL'i und der Wortleitung WL'j, an dem das Speicherelement S'i, j angeordnet ist, die Magnetisierung der ersten ferromagnetischen Schicht des Speicherelementes S'i,j und damit der Widerstand des Speicherelementes S'i,j geändert wird. An allen anderen Speicherelementen der Bitleitung BL'i und der Wortleitung WL'j reicht das Magnetfeld dabei nicht aus, die Magnetisierung und damit den Widerstand zu ändern. Abhängig von der Stromrichtung wird so der größere oder der kleinere Wert des Widerstands in das Speicherelement S'i,j programmiert.

Zum Auslesen der Speicherzellenanordnung wird an die Wortleitungen WL'j, j = 1 ... m ein Signal in Form eines Eingangsvektors X mit m Komponenten gelegt. Die Komponenten von X nehmen dabei die Werte 0 Volt oder Vdd an. Vdd beträgt zum Beispiel 1 Volt. In die Bitleitung BL'i fließt über die Speicherelemente S'i, j,j = 1 ... m ein Strom. Die Summe dieser Ströme fließt durch den Rückkoppelwiderstand RK'i, da der Operationsverstärker OP'i einen sehr hohen Eingangswiderstand, zum Beispiel $\geq 100$ Mega-Ohm, aufweist und eine solche Spannung Ui einstellt, daß die Bitleitung BL'i auf 0 Volt geregelt wird. Die Schwellwertelemente SWi bilden aus den Spannungen Ui des Operationsverstärkers OP'i Ausgangsgrößen Yi, die die Werte 0 Volt oder Vdd annehmen können.

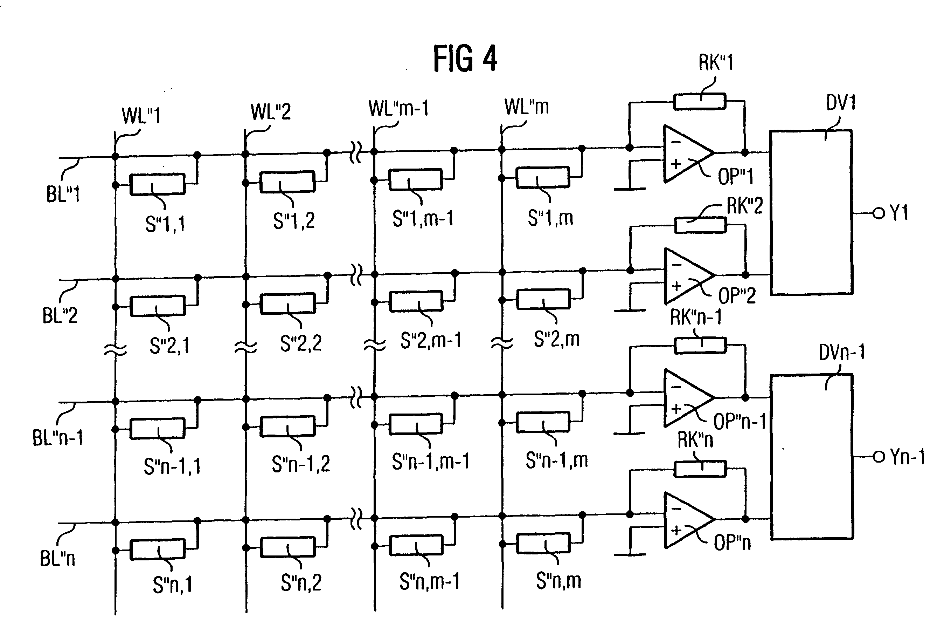

Eine weitere Speicherzellenanordnung, die ebenfalls als assoziativer Speicher geeignet ist, weist untereinander im wesentlichen parallel verlaufende Wortleitungen WL"j, j = 1 ... m und quer dazu verlaufende, untereinander im wesentlichen parallel verlaufende Bitleitungen BL"i, i = 1 ... n, auf (siehe Figur 4). An den Kreuzungspunkten der Bitleitungen BL"i und der Wortleitungen WL"j ist jeweils ein Speicherelement S"i,j angeordnet, das analog wie in den zuvor beschriebenen Ausführungsbeispielen aufgebaut ist. Die Bitleitungen BL"i sind jeweils mit dem invertierenden Eingang eines Operationsverstärkers OP"i verbunden, dessen nicht invertierender Eingang auf Erdpotential liegt und der rückgekoppelt ist. Die Operationsverstärker OP"i weisen einen Rückkopplungswiderstand RK"i auf. Der Ausgang der Operationsverstärker OP"i, OP"i+1 von benachbarten Bitleitungen BL"i, BL"i+1 sind mit den Eingängen eines Differenzverstärkers DVi, i = 1, 3, 5, ... n-1, verbunden (siehe Figur 4).

Das Einschreiben von Information in diese Speicherzellenanordnung erfolgt analog wie anhand von Figur 3 geschildert. Dabei werden die Speicherelemente S"i,j, S"i+1,j von benachbarten Bitleitungen BL"i, BL"i+1, die mit demselben Differenzverstärker DVi verbunden sind, komplementär programmiert.

Beim Auslesen, das analog zu dem anhand von Figur 3 geschilderten Ausführungsbeispiel erfolgt, wird auf der einen Bitleitung BL"i das komplementäre Signal der anderen Bitleitung BL"i+1 gebildet. Die Ausgangsspannungen Ui, Ui+1 der Operationsverstärker OP"i, OP"i+1 werden auf einen Differenzverstärker DVi gegeben, der das Ausgangssignal Yi bildet. Dadurch werden Störeinflüsse, die zum Beispiel auf Prozeßschwankungen zurückzuführen sind, eliminiert.

**Patentansprüche**

1. Speicherzellenanordnung,

   - bei der mehrere untereinander im wesentlichen parallel verlaufende Wortleitungen (WLj) und mehrere untereinander im wesentlichen parallel verlaufende Bitleitungen (BLi) vorgesehen sind, wobei die Wortleitungen (WLj) quer zu den Bitleitungen (BLi) verlaufen,

- bei der Speicherelemente (Si,j) mit einer Schichtstruktur mit sehr großem magnetoresistivem Effekt (GMR) vorgesehen sind, die jeweils zwischen eine der Wortleitungen (WLj) und eine der Bitleitungen (BLi) geschaltet sind und die hochohmiger als die Wortleitungen (WLj) und die Bitleitungen (BLi) sind,

- bei der die Bitleitungen (BLi) jeweils mit einem Leseverstärker (OPi) verbunden sind, über den das Potential an der jeweiligen Bitleitung (BLi) auf ein Referenzpotential regelbar ist und an dem ein Ausgangssignal abgreifbar ist.

2. Speicherzellenanordnung nach Anspruch 1, bei der der Leseverstärker einen rückgekoppelten Operationsverstärker (OPi) aufweist.

3. Speicherzellenanordnung nach Anspruch 1 oder 2,

- bei der die Speicherelemente (Si,j) jeweils zwei ferromagnetische Schichten (1, 3) und eine dazwischen angeordnete nicht magnetische Schicht (2) aufweisen,

- bei der eine antiferromagnetische Schicht (4) vorgesehen ist, die einer der ferromagnetischen Schichten (3) benachbart ist und die die Polarisationsrichtung der Magnetisierung in der benachbarten ferromagnetischen Schicht (3) bestimmt,

- bei der die Speicherelemente (Si,j) jeweils zwei Magnetisierungszustände aufweisen.

4. Speicherzellenanordnung nach Anspruch 3,

- bei der die ferromagnetischen Schichten (1, 3) jeweils mindestens eines der Elemente Fe, Ni, Co, Cr, Mn, Gd enthalten,

- bei der die Dicke der ferromagnetischen Schichten (1, 3) jeweils kleiner oder gleich 20 nm ist,

- bei der die nicht magnetische Schicht (2) mindestens eines der Materialien $Al_2O_3$, NiO, $HfO_2$, $TiO_2$, NbO, $SiO_2$ enthält und eine Dicke im Bereich zwischen 1 und 4 nm aufweist.

5. Speicherzellenanordnung nach einem der Ansprüche 1 bis 4, bei der die Speicherelemente (Si,j) in einer Ebene, die von den Wortleitungen (WLj) und den Bitleitungen (BLi) aufgespannt wird, Abmessungen im Bereich zwischen 0,1 μm x 0,1 um und 2 um x 20 μm aufweisen.

6. Speicherzellenanordnung nach einem der Ansprüche 1 bis 5, bei der die Zahl der Wortleitungen (WLj) größer als die Zahl der Bitleitungen (BLi) ist.

7. Speicherzellenanordnung nach einem der Ansprüche 1 bis 6, bei der im wesentlichen parallel verlaufende Schreibleitungen (SLi) vorgesehen sind, die gegenüber den Wortleitungen (WLj) und den Bitleitungen (BLi) isoliert sind.

8. Speicherzellenanordnung nach einem der Ansprüche 1 bis 6, bei der zu den Bitleitungen (BL'i) Schwellwertelemente (SWi) vorgesehen sind, die jeweils mit dem Ausgang des Leseverstärkers (OP'i) verbunden sind.

9. Speicherzellenanordnung nach einem der Ansprüche 1 bis 7, bei der jeweils zu zwei Bitleitungen (BL"i, BL"i+1) ein Differenzverstärker (DVi) vorgesehen ist, dessen Eingänge jeweils mit den Ausgängen der Leseverstärker (OP"i) der zugehörigen Bitleitungen (BL"i) verbunden ist.

10. Verwendung der Speicherzellenanordnung nach einem der Ansprüche 1 bis 7 als magnetisches RAM.

11. Verwendung der Speicherzellenanordnung nach Anspruch 8 oder 9 als assoziativer Speicher..

**Claims**

1. Memory cell arrangement,

- in which a plurality of word lines (WLj) running essentially parallel to one another and a plurality of bit lines (BLi) running essentially parallel to one another are provided, the word lines (WLj) running transversely with respect to the bit lines (BLi),
- in which memory elements (Si, j) having a layer structure with a giant magnetoresistive effect (GMR) are provided, which memory elements are respectively connected between one of the word lines (WLj) and one of the bit lines (BLi) and have a higher resistance than the word lines (WLj) and the bit lines (BLi),
- in which the bit lines (BLi) are each connected to a sense amplifier (OPi) by means of which the potential on the respective bit line (BLi) can be regulated to a reference potential and at which an output signal can be picked off.

2. Memory cell arrangement according to Claim 1, in which the sense amplifier has a feedback operational amplifier (OPi).

3. Memory cell arrangement according to Claim 1 or 2,

- in which the memory elements (Si, j) each have two ferromagnetic layers (1, 3) and a non-magnetic layer (2) arranged in between,
- in which an antiferromagnetic layer (4) is provided, which is adjacent to one of the ferromagnetic layers (3) and determines the polarization direction of the magnetization in the adjacent ferromagnetic layer (3),
- in which the memory elements (Si, j) each have two magnetization states.

4. Memory cell arrangement according to Claim 3,

- in which the ferromagnetic layers (1, 3) each contain at least one of the elements Fe, Ni, Co, Cr, Mn, Gd,
- in which the thickness of the ferromagnetic layers (1, 3) is in each case less than or equal to 20 nm,
- in which the non-magnetic layer (2) contains at least one of the materials $Al_2O_3$, NiO, $HfO_2$, $TiO_2$, NbO, $SiO_2$ and has a thickness in the range between 1 and 4 nm.

5. Memory cell arrangement according to one of Claims 1 to 4,
in which the memory elements (Si, j), in a plane spanned by the word lines (WLj) and the bit lines (BLi), have dimensions in the range between 0.1 µm x 0.1 µm and 2 µm x 20 µm.

6. Memory cell arrangement according to one of Claims 1 to 5,
in which the number of word lines (WLj) is greater than the number of bit lines (BLi).

7. Memory cell arrangement according to one of Claims 1 to 6,
in which write lines (SLi) running essentially parallel are provided, and are insulated from the word lines (WLj) and the bit lines (Bli).

8. Memory cell arrangement according to one of Claims 1 to 6,
in which the threshold value elements (SWi) are provided with regard to the bit lines (BL'i), which elements are in each case connected to the output of the sense amplifier (OP'i).

9. Memory cell arrangement according to one of Claims 1 to 7,
in which a differential amplifier (DVi) is provided in each case with regard to two bit lines (BL"i, BL"i+1), the inputs of which amplifier is in each case connected to the outputs of the sense amplifiers (OP"i) of the associated bit lines (BL"i).

10. Use of the memory cell arrangement according to one of Claims 1 to 7 as a magnetic RAM.

11. Use of the memory cell arrangement according to Claim 8 or 9 as an associative memory.

## Revendications

1. Dispositif de cellule de mémoire,

- dans lequel plusieurs lignes (WLj) de mots s'étendant sensiblement parallèlement les unes aux autres et plusieurs lignes (BLi) de bits s'étendant sensiblement parallèlement les unes aux autres sont prévues, les lignes (WLj) de mots s'étendant transversalement aux lignes (BLi) de bits,
- dans lequel il est prévu des éléments (Si, j) de mémoire, qui ont une structure stratifiée à très grand effet magnétorésistif (GMR), qui sont branchés respectivement entre l'une de lignes (WLj) de mots et l'une des lignes (BLi) de bits et qui sont à plus grande impédance que les ligne (WLj) de mots et les lignes (BLi) de bits,
- dans lequel les lignes (BLi) de bits sont reliées respectivement à un amplificateur (OPi) de lecture par l'intermédiaire duquel le potentiel sur la ligne (BLi) de bits associée peut être réglé à un potentiel de référence et sur lequel un signal de sortie peut être prélevé.

2. Dispositif de cellule de mémoire suivant la revendication 1, dans lequel l'amplificateur de lecture comporte un amplificateur (OPi) opérationnel rétrocouplé.

3. Dispositif de cellule de mémoire suivant la revendication 1 ou 2,

- dans lequel les élément (Si, j) de mémoire comportent respectivement deux couches (1, 3) ferromagnétiques et une couche (2) non magnétique disposée entre les deux,
- dans lequel il est prévu une couche (4) antiferromagnétique qui est voisine de l'une des couches (3) ferromagnétiques et qui détermine la direction de polarisation de l'aimantation dans la couche (3) ferromagnétique voisine,
- dans lequel les éléments (Si, j) de mémoire comportent respectivement deux états d'aimantation.

4. Dispositif de cellule de mémoire suivant la revendication 3,

- dans lequel les couches (1, 3) ferromagnétiques contiennent respectivement au moins l'un des éléments Fe, Ni, Co, Cr, Mn Gd,

- dans lequel l'épaisseur des couches (1, 3) ferromagnétiques est respectivement inférieure ou égale à 20 nm,
- dans lequel la couche (2) non magnétique contient au moins l'un des matériaux $Al_2O_3$, NiO, $HfO_2$, $TiO_2$, NbO, $SiO_2$ et a une épaisseur dans l'intervalle entre 1 et 4 nm.

5. Dispositif de cellule de mémoire suivant l'une des revendications 1 à 4, dans lequel les éléments (Si, j) de mémoire dans un plan qui passe par les lignes (WLj) de mots et les lignes (BLi) de bits ont des dimensions dans l'intervalle entre 0,1 μm x 0,1 μm et 2 μm x 20 μm.

6. Dispositif de cellule de mémoire suivant l'une des revendications 1 à 5, dans lequel le nombre des lignes (WLj) de mots est supérieur au nombre de lignes (BLi) de bits.

7. Dispositif de cellule de mémoire suivant l'une des revendications 1 à 6, dans lequel il est prévu des lignes (SLi) d'écriture qui s'étendent sensiblement parallèlement et qui sont isolées des lignes (WLj) de mots et des lignes (BLi) de bits.

8. Dispositif de cellule de mémoire suivant l'une des revendications 1 à 6, dan lequel il est prévu pour les lignes (BL'i) de bits des éléments (SWi) à valeur seuil qui sont reliés respectivement à la sortie de l'amplificateur (OP'i) de lecture.

9. Dispositif de cellule de mémoire suivant l'une des revendications 1 à 7, dans lequel il est prévu respectivement pour deux lignes (BL"i, BL"i + 1) de bits, un amplificateur (DVi) différentiel dont les entrées sont reliées respectivement aux sorties des amplificateurs (OP"i) de lecture des lignes (BL"i) de bits associées.

10. Utilisation du dispositif de cellule de mémoire suivant l'une des revendications 1 à 7 comme RAM magnétique.

11. Utilisation du dispositif de cellule de mémoire suivant la revendication 8 ou 9 comme mémoire associative.

FIG 1

EP 1 016 087 B1

FIG 2

BLi

Si,j

4
3
2
1

WLj

SLi

S

# FIG 3

EP 1 016 087 B1

# FIG 4

EP 1 016 087 B1